# EUROPEAN PATENT APPLICATION

(11) **EP 2 530 711 A1**
(43) Date of publication of application: **05.12.2012**
(21) Application number: 11168071.6
(22) Date of filing: 30.05.2011
(51) Int. Cl.: H01L 25/07, H01L 23/62

(54) **Power semiconductor arrangement**

(71) Applicant: ABB Research Ltd., 8050 Zürich (CH)
(72) Inventor: Schulz, Nicola, 5300 Turgi (CH); Wildner, Franz, 5064 Wittnau (CH); Christen, Thomas, 5413 Brimenstorf (CH); Schuderer, Juergen, 8047 Zürich (CH)
(74) Representative: ABB Patent Attorneys

(57) **Abstract**

The present invention relates to a power semiconductor arrangement comprising a power semiconductor device (14), having an emitter electrode and a collector electrode, wherein the collector electrode is electrically connected to a lower electrode (16) and the emitter electrode is electrically connected to an upper electrode (18), wherein the power semiconductor device (14) is arranged to at least one further power semiconductor device in parallel. In order to allow the power semiconductor arrangement (10) to provide an electrical short-circuit mode after a failure event having an improved reliability as well as durability, the arrangement (10) further comprises a high energy material (34) being connected to the power semiconductor device (14) and being connected to at least one failure current bypass unit (36, 54, 70), the failure current bypass unit (36, 54, 70) being arranged in parallel to the power semiconductor device (14) and being activatable by the high energy material (34) to form a current bypass.

## Description

### Technical Field

The Invention relates to a power semiconductor arrangement. In particular, the invention relates to a power semiconductor arrangement with the capability to fall into a stable electrical short circuit after a failure event. The invention further relates to a power semiconductor module comprising a power semiconductor arrangement.

### Background Art

In the case of high power semiconductor arrangements, or modules, respectively, it has been found that a defect leads to the formation of an electrical short circuit. With large chip areas, this short circuit remains stable over a long time. If, for example, redundant thyristors are provided in a stack of thyristors connected in series, the remaining, intact thyristors withstand the voltage during the switched-off phase, and the stack remains operative. Defective thyristors can be replaced subsequently in the course of planned servicing work.

In a thyristor module, for example, the semiconductor, that is to say the silicon (Si), is in mechanical and electrical contact with and arranged between two molybdenum wafers. Silicon has a melting point of 1420°C, wherein that of molybdenum is higher, and the intermetallic compounds of silicon and molybdenum have a still higher melting point. Thus, in the event of a defect, the silicon melts locally first of all and, as current flows, it forms a conductive channel composed of molten silicon over the entire thickness of the semiconductor. This defect zone can propagate and/or move, but will only affect a small part of the chip area. In hermetically sealed housings, the molten silicon does not oxidize but reacts with molybdenum to form a type of powder. This process continues until all the silicon has been consumed, and may possibly extend over years.

In contrast to thyristor semiconductor components, insulated gate bipolar transistor (IGBT) chips, for example, are not produced as large-area units and, normally, a plurality of small-area individual chips are arranged isolated and alongside one another in the insulated gate bipolar transistor modules.

It has been found that no long-term stable short circuits of the type described above can be expected with insulated gate bipolar transistor modules, for example. This is primarily due to the reduced area of the individual chips, and the small silicon volume. The pseudo-stable phase of a short circuit lasts for only a few hours in this case. Furthermore, the housings are often deliberately not hermetically sealed, so that the molten silicon can react with oxygen and form insulating silica (SiO₂). Without any stable short-circuit path in the defective chip, the worst-case situation which can arise is as follows. If the remaining chips in a module, including the actuation, are still intact, they can withstand voltage during the switched-off phase. The current is then forced through the defective chip and, at voltages up to the break down voltage of the intact chips, the current may lead to a plasma being formed, with a very high power density. This results in the entire module being destroyed.

To avoid this problem, known from EP 0 989 611 B1 is a power semiconductor module which is formed from small-area individual chips and in which a short circuit of an individual chip does not lead to total failure of the module. According to this prior art, a layer composed of a suitable material, for example, silver or aluminium, is brought into direct contact with one or both of the main electrodes of the silicon semiconductor. The material of this layer must form an eutectic mixture with silicon. In the event of a short circuit, the entire sandwich structure is heated and, once the melting point of the eutectic mixture is reached, a conductive melt starts to form on the contact surface between the said layer and the silicon. This zone can then expand over the entire thickness of the semiconductor, and thus form a metallically conductive channel. A sufficient electric contact is thereby provided by means of an electric contact piston.

However, such a technology may in some cases suffer from a reduced lifetime of the conductive channel (or short circuit failure mode), since the conductive alloy ages with time and ages faster at elevated currents and thus higher temperatures. In this way, the technology may be problematic to be scaled to considerably higher power ratings. It is reported in literature that the mechanisms responsible for this aging are the formation of brittle intermetallics (AI, Si, Mo) and the presence of intermetallic corrosion leading to loss of chip adhesion.

Furthermore, known from EP 1 282 170 A1 is a short circuit proof semiconductor device. This device comprises a burning element with a high energy material. The high energy material may be activated such that an exothermal reaction occurs within the material. This has the effect of high temperatures to be created resulting in an alloy to be formed through the whole thickness and area of the semiconductor chip which reduces the electrical resistance of the alloy and improves the overall stability of the electrical short-circuit.

In some case, however, it might be insufficient to provide electronic devices, such as semiconductor devices, or modules like described above, to react to a failure, because a damage of the electronic arrangement may in some cases not completely be avoided.

### Summary of invention

It is therefore an object of the present invention to provide an improved power semiconductor arrangement and an improved power semiconductor module which shall obviate at least one of the disadvantages known in the art.

In particular, it is an object of the present invention to provide a power semiconductor arrangement and a power semiconductor module which provide a short circuit failure mode capacity with an improved reliability as well as durability and current carrying capability.

These objects are achieved by a power semiconductor arrangement according to claim 1. These objects are furthermore achieved by a power semiconductor module according to claim 15. Preferred embodiments of the present invention are defined in the dependent claims.

The invention relates to a power semiconductor arrangement comprising a power semiconductor device, having an emitter electrode and a collector electrode, wherein the collector electrode is electrically connected to a lower electrode and the emitter electrode is electrically connected to an upper electrode, wherein the power semiconductor device is arranged to at least one further power semiconductor device in parallel, wherein the arrangement further comprises a high energy material being connected to the power semiconductor device and being connected to at least one failure current bypass unit, the failure current bypass unit being arranged in parallel to the power semiconductor device and being activatable by the high energy material to form a current bypass.

A lower electrode in the sense of the present invention may be any electrode the collector electrode of the semiconductor device is preferably electrically connected to. For example, the lower electrode may be formed by a conventional metallic base plate. Accordingly, an upper electrode may be any electrode the emitter electrode of the semiconductor device is preferably electrically connected to. For example, the upper electrode may be formed by a conventional metallic lid.

Referring to this, a collector electrode or a emitter electrode being electrically connected to a lower electrode or upper electrode, respectively, shall particularly mean, that the emitter electrode and the collector electrode is directly connected to the respective further electrode, or that one or a plurality of electrically conductive parts, or layers, respectively, are arranged there between. Additionally, the power semiconductor device is arranged to at least one further power semiconductor device in parallel.

According to the invention, a high energy material shall furthermore particularly mean a material which performs an exothermal reaction due to an activation step, particularly due to an energy input. In detail, the high energy material may be activated by heat, vibration, mechanical stress, a flame, high local current density, a spark, an arc, a laser spot, needle pressing or the like. For example, the high energy material may perform an exothermal solid-state reaction resulting in an intermetallic phase formation.

The exothermal reaction thus may particularly be activated by an input of heat or mechanical energy and produces elevated temperatures. The amount of energy or temperature released may be tailored to the desired application.

A high energy material being connected to the power semiconductor device according to the present invention shall particularly mean a high energy material being in contact with the power semiconductor device such that heat being potentially generated by a failure or defect of the power semiconductor device is transferable to the high energy material and thus activates the same.

A failure current bypass unit according to the invention shall particularly mean any unit or element, respectively, which is capable of forming a current bypass in case the semiconductor device has a failure thereby bypassing the semiconductor device having a failure, or defect, respectively. It forms the current bypass and is thus activatable by the reaction of the high energy material.

Consequently, due to the provision of the high energy material being connected to the power semiconductor device, the heat generated due to the failure activates the high energy material. By connecting the high energy material to at least one failure current bypass unit, energy, especially heat, is imposed to the at least on failure current bypass unit thereby forming a current bypass bypassing the defect power semiconductor device. The at least one failure current bypass unit may thus act as a kind of victim element. It allows the short-circuit current being generated by the failure of the semiconductor device being distributed over at least two, preferably a plurality of several parallel current paths. The high energy material may thereby be connected to the failure current bypass unit directly or via a further element. It may thus directly activate the failure current bypass unit, or it may trigger a further element which in turn activates the failure current bypass unit. In the latter case, the high energy material indirectly activates the failure current bypass unit.

Especially in case the lower electrode is formed by or is part of a base plate, the latter is cooled in order to transport heat from the power semiconductor device. Consequently, the formed electrical contact is cooled as well resulting in an especially stable and durable contact being able to carry high currents even over a long period of time. This allows the short-circuit capability being formed after the semiconductor chip failure having an especially high durability.

Additionally, due to the fact that the failure current bypass unit is activatable solely by the influence of the generated heat and thus exclusively by the physical effects occurring during and after the failure of the power semiconductor device, an autonomous formation of an electrical bypass is provided. Consequently, no further external means for triggering the bypass formation are required leading to an improved reliability of the electrical bypass of the power semiconductor arrangement according to the invention.

Apart from that, the arrangement according to the invention is compatible to the general layout being provided for power semiconductor arrangements, or power semiconductor modules, respectively, in particular being equipped with a spring biased contact piston at the emitter side for contacting the power semiconductor device. Consequently, the implementation of the power semiconductor arrangement into a variety of applications is not problematic leading to a great application width of the power semiconductor arrangement according to the invention.

The power semiconductor arrangement according to the invention thus improves the current carrying capability in case a failure of the power semiconductor device appears and furthermore allows a longer lifetime of the arrangement in its short-circuit state, since the local current density is reduced. The power semiconductor arrangement according to the invention thus addresses the above identified objects and provides a reliable and permanent short-circuit capability being formed if a semiconductor chip fails.

In a preferred embodiment of the present invention the at least one failure current bypass unit comprises a power semiconductor device. This embodiment provides an especially easy and cost-saving implementation of the power semiconductor arrangement according to the invention into conventional arrangements. In detail, solely the high energy material has to be added and connected to the respective power semiconductor devices. In case of a failure of a power semiconductor device, at least one further semiconductor device is used as victim element. Energy is implemented into the victim element in order to generate a stable current bypass. This may be performed by providing an alloy forming material being present adjacent to this semiconductor of the victim element which may generate an alloy with the semiconductor of the victim element. It is thereby possible to connect a high energy material to only two power semiconductor devices, or to connect one or more high energy materials to a sub-group of power semiconductor devices comprising a suitable number of semiconductor devices. The number may thereby be chosen in dependence of the respective requirements, e.g. especially the current flowing requirements. Furthermore, in this case, the failure current bypass unit may comprise the at least one power semiconductor arrangement being arranged in parallel to the power semiconductor arrangement as such.

It may furthermore be preferred that the at least one failure current bypass unit comprises a current conductor being disconnected by an electrical insulator, the electrical insulator being at least partly destructible by the high energy material. This embodiment allows using a failure current bypass unit being provided solely for generating a current bypass in case a power semiconductor device fails. Consequently, no power semiconductor devices are destroyed as victim elements in case of a failure, but only the electrical insulator of the current conductor is damaged or at least partly destroyed. This embodiment allows an easy exchange of the respective parts in service work after a failure. Additionally, the current conductor may be designed to carry a defined and high current allowing a limited number of current conductors only to be present in a module, for example. Each current conductor may thereby be connected to a plurality of high energy materials. The failure current bypass unit may in this case be arranged inside a module comprising the arrangement according to the invention, or outside the arrangement, solely connected to the latter via the high energy material, for example. An at least partly destructible insulator shall thereby mean that the insulator melts, evaporates or is damaged in a further way, thereby allowing the current conductor to be able of carrying current.

With this regard, it may be preferred that the electrical insulator is arranged between to electrical contact parts, wherein at least one contact part is pressed against the insulator by a spring loaded contact piston. Consequently, in case the insulator melts or is damaged due to the activation of the high energy material, the contact piston presses the electrical contact parts against each other thereby forcing the insulator to move beside resulting in a good electrical contact of the contact parts. This embodiment thus allows providing an especially reliable and durable contact of the respective electrical contact parts. The insulator may be formed of polypropylene, for example, and may be formed as a foil or sheet.

According to a further embodiment of the present invention, an alloy forming element is provided being connected to the power semiconductor device. An alloy forming element being connected to the semiconductor device shall particularly mean an element comprising or consisting of a material which is capable of reacting with the semiconductor of the power semiconductor device, such as the silicon. It may then form an alloy, or preferably an eutectic alloy, respectively with the semiconductor due to a heat impact being generated by a failure or a defect of the semiconductor device, for example. Consequently, in the event of a short circuit, the entire sandwich structure is heated and, once the melting point of the eutectic mixture is reached, a conductive melt or alloy, respectively, starts to form on the contact surface between the said layer and the silicon. This zone can then expand over the entire thickness of the semiconductor, and thus form a metallically conductive channel.

In detail, in case a power semiconductor device fails, heat is generated through a formed short circuit. The generated heat leads to the alloy forming element to react with the power semiconductor device, or the semiconductor of the latter, respectively, and to form an electrically conductive path through the semiconductor device in order to generate a stable electrical short circuit.

According to a still further embodiment of the present invention, it may be preferred that the high energy material is connected to a high energy element. In detail, it may be preferred that the high energy material is connected to at least one failure current bypass unit via the further high energy material, or the high energy element, respectively. This embodiment allows using a material as high energy material which generates a limited amount of energy, or heat, respectively, only. This limited amount of heat may be insufficient to activate the failure current bypass unit, but it may be sufficient to activate the high energy element. In this case, the high energy material triggers a reaction of the high energy element, the latter leading to the failure current bypass unit to be activated and to generate the current bypass. Consequently, the high energy material indirectly activates the failure current bypass unit via the high energy element. This embodiment may be preferred, for example, in case the failure current bypass unit is located outside a module which comprises the arrangement according the invention in order to reduce the heat generated inside the module. Additionally, according to this embodiment, the activation energy of the high energy material may be reduced, allowing further improving the reliability of the failure mode according to the invention. The high energy element may thus comprise or be formed of a further high energy material which releases a higher energy compared to the high energy material. It may thus at least partly take the place of the high energy material.

With this regard, it may furthermore be preferred that the high energy element comprises at least two different compounds being capable of reacting with each other thereby releasing energy, or heat, respectively, and being separated from each other by a separator, the separator being at least partly destructible by the high energy material. This embodiment allows implementing a great number of potentially usable further high energy materials, for example an oxidant and a reducer, which may be tailored to the desired application.

In a further preferred embodiment of the present invention, a mechanically loaded contact arm is provided being activatable by the high energy material thereby closing a current bypass. This is a further easy way to generate a current bypass which is easily implementable into power semiconductor arrangements known as such. Additionally, a current bypass may be generated without a serious damage of a power semiconductor device allowing an easy and cost-saving servicing work after a failure.

According to a further preferred embodiment of the present invention, the high energy material is formed as a layer structure comprising a plurality of alternating layers. In detail, the layer structure may comprise two materials reacting with each other in an exothermic way. In this case, a connection is particularly easy to form leading to the arrangement as such to be designed essentially without limitations.

Additionally, the amount of energy release may be tailored to the desired application, i.e. especially with respect to the heat being required from the failure current bypass unit to work properly. Furthermore, the activation both of the high energy material as well as of the failure current bypass unit may be performed very localized thus concentrating the released energy.

With regard to the layer structure, it is especially preferred that it comprises alternating aluminium layers and nickel layers. Such a layer structure may perform an especially suitable exothermic reaction. In detail, an intermetallic structure comprising nickel and aluminium is formed, wherein temperatures of up to 1200 °C are formed. Consequently, the energy formed is high enough for most failure current bypass units to be activated and to work securely. This embodiment thus further improves the reliability of the activation of the failure current bypass unit and further reduces the danger of the electronic arrangement to be damaged.

Additionally, such layers may be formed in an easy manner and they are inert with respect to each other and against oxidation at normal operation conditions. Consequently, the layer structure and thus the high energy material is producible cost-saving and has a long lifetime without the need of the material to be exchanged.

The layer structures, and especially the one formed of aluminium and nickel layers, furthermore may be designed to have a very long lifetime, also at elevated temperatures, for example at above 60°C or even at above 100°C. A further advantage of the usage of a high energy material comprising aluminium and nickel is the fact that an intermetallic structure is formed which reaction is completely solid-state. Consequently, no gas is formed which is especially preferred if the connection and thus the high energy material is at least partly located inside an electronic device.

According to a further preferred embodiment of the present invention, at least one layer comprises a mixed material zone. Preferably, each layer comprises a mixed material zone. According to the invention, a mixed material zone shall mean a region of the layer, preferably at its outer side, in which it is formed not only of the main substance thereof, but additionally of a further material. Preferably, this material corresponds to the adjacent layer. Consequently, in the case of the alternating layers being formed of nickel and aluminium, the nickel layer comprises aluminium, preferably adjacent to the aluminium layer, whereas the aluminium layer comprises nickel in this zone, preferably adjacent to the nickel layer. This embodiment improves the activation of the high energy material and thus the start of the exothermic reaction. The energy input being required for the exothermic reaction to start may thus be reduced, and furthermore adapted to the desired application. This embodiment thus allows a high flexibility of the design of the electronic arrangement according to the invention.

According to a still further embodiment of the present invention, the layers each have a thickness in the range of ≥ 1 nm to ≤ 100nm. This embodiment enables an especially fast reaction and thus a high velocity of propagation through the high energy material and thus from the power electronic device to the failure current bypass unit. In detail, due to the fact the layers have a thickness in the above identified range, even the material being located in the middle part of the respective layer is located close and in vicinity to a further respective layer. Consequently, a propagation of the reaction through the high energy material and thus to the failure current bypass unit is improved allowing the reaction time of the failure current bypass unit with respect to a failure, or defect, to occur to be minimized.

It is furthermore preferred, that the high energy material is arranged in the form of a foil or stripe. This is an especially easy way to form a connection of the high energy material between the power electronic device and the failure current bypass unit. Consequently, an arrangement according to this embodiment is especially easy and cost-saving to form.

According to a further preferred embodiment of the present invention, the high energy material is formed as a mixture of solid particles. In detail, it is preferred that the mixture of particles comprises materials being capable of reacting with each other in an exothermic way. As an example, the mixture may comprise nickel particles as well as aluminium particles. This embodiment allows tailoring the heat to be released by the exothermic reaction in an especially easy way by using the desired ratio and concentration of particles in the high energy material.

The invention furthermore relates to a power semiconductor module comprising a power semiconductor arrangement according to the invention.

According to the module, it is especially preferred if the module comprises at least two power semiconductor devices being arranged in parallel in case one power semiconductor device may be used as victim device like described above. In case a further failure current bypass unit is used, the module preferably comprises at least two power semiconductor devices arranged in parallel and one or more failure current bypass units being arranged in parallel to the power semiconductor devices.

### Brief description of drawings

Additional features, characteristics and advantages of the subject-matter of the invention are disclosed in the subclaims, the figures and the following description of the respective figures and examples, which -in an exemplary fashion- show one embodiment and example of a semiconductor arrangement according to the invention.

In the figures:

Figure 1 shows a sectional side view of an embodiment of a power semiconductor arrangement according to the invention;

Figure 2 shows a sectional side view of an embodiment of the high energy material being part of the power semiconductor arrangement according to the invention;

Figure 3 shows a sectional side view of a further embodiment of a power semiconductor arrangement according to the invention; and

Figure 4 shows a sectional side view of a further embodiment of a power semiconductor arrangement according to the invention.

### Description of embodiments

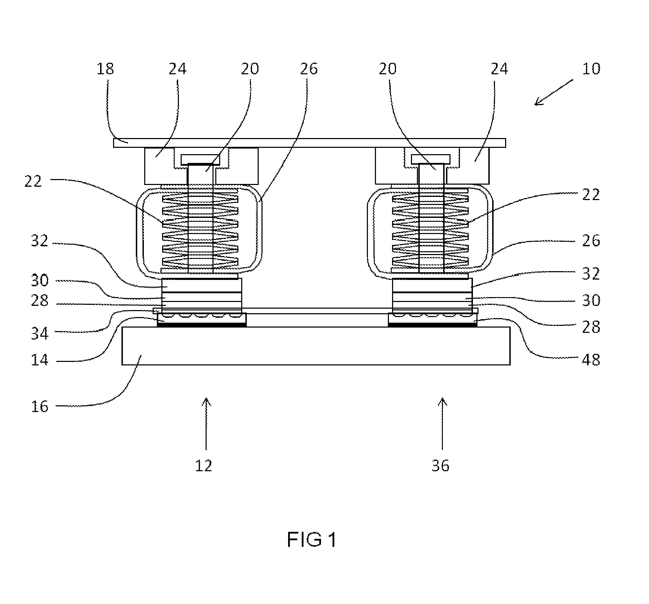

In figure 1, an embodiment of the power semiconductor arrangement 10 according to the invention is schematically shown. It is obvious for one skilled in the art that a plurality of arrangements 10 shown in figure 1 may be combined to a power semiconductor module. The arrangement 10 according to the invention is particularly suitable for a high-voltage direct current (HVDC) - electric power transmission system or a flexible AC transmission system (FACTS).

According to figure 1, the power semiconductor arrangement 10 comprises a first unit 12 comprising a power semiconductor device 14 having an emitter electrode and a collector electrode. The power semiconductor device 14 may be an insulated gate bipolar transistor (IGBT), a reverse conductive insulated gate bipolar transistor (reverse conducting IGBT), or a bi-mode insulated gate transistor (BIGT), for example. However the power semiconductor device 14 is not limited to the above described examples. The collector electrode is electrically connected to a lower electrode 16, for example a base plate, wherein the emitter electrode is electrically connected to an upper electrode 18, for example a lid of the arrangement 10.

Additionally, a contact piston 20 may be provided, preferably being spring loaded by a spring 22. The contact piston 20 contacts the power semiconductor device 14 and presses the latter towards the lower electrode 16. The contact piston 20 may be connected to the upper electrode 18 by one or more electrically conductive connectors 24. Additionally, at least partly surrounding the spring 22 and the contact piston 20, at least one current bypass 26 may be provided.

Preferably on top of the semiconductor device 14, or adjacent to the emitter electrode, respectively, an alloy forming element comprising a material forming an electrically conductive alloy, or an eutectic alloy, respectively, with the silicon of the power semiconductor device 14 due to heat influence generated by a defect in the semiconductor device 14 may be provided. The alloy forming element is thus capable of forming an electrically conductive path through the power semiconductor device 14 in case of a failure of the power semiconductor device 14. The alloy forming element may be formed of or contain a material such as aluminium (Al), silver (Ag), copper (Cu) or gold (Au).

Additionally, further layers 28, 30 and 32 may be provided in the unit 12 according to the desired application of the power semiconductor arrangement 10 which are known to one skilled in the art and are not described here in detail. These layers may fulfil functionalities such as compensation of different coefficients of thermal expansion or they may improve mechanical support.

According to the invention, the arrangement 10 further comprises a high energy material 34. The high energy material 34 is connected at its one side to the power semiconductor device 14, preferably at its emitter surface. Consequently, in case the semiconductor device 14 has a failure, a high short-circuit current flows through the failed semiconductor device 14 and in turn generates heat. The generated heat will then activate the high energy material 34. Due to the fact that the high energy material 34 is additionally connected at its further side to at least one failure current bypass unit 36, the latter may be activated by the high energy material 34 thus forming a current bypass. Consequently, the high energy material 34 forms a kind of energy connection between the power semiconductor device 14 and the failure current bypass unit 36. In case the power semiconductor device 14 is arranged to the failure current bypass unit 36 in parallel the short-circuit current flow is distributed over at least two parallel current paths. In detail, the short-circuit current flows through the semiconductor device 14 and thus through the unit 12 as well as through the current bypass formed by the failure current bypass unit 36.

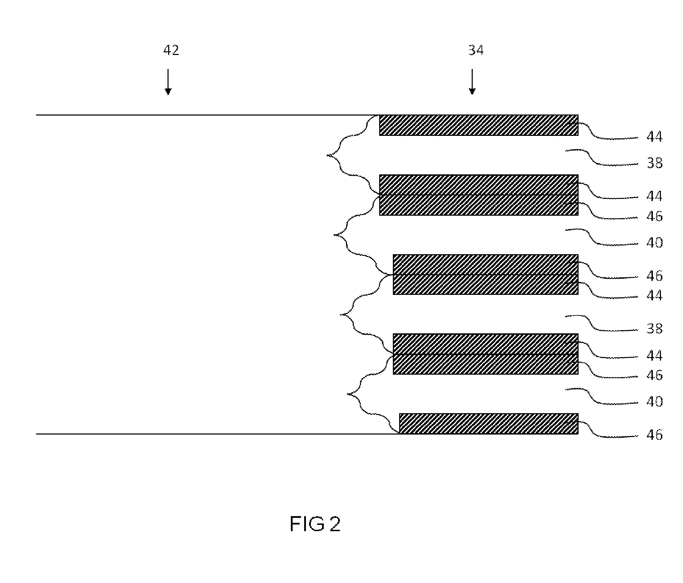

A preferable embodiment of the high energy material 34 according to the invention is shown in figure 2.

According to figure 2, the high energy material 34 is formed as a layer structure comprising a plurality of alternating layers 38 and 40. The layers 38, and 40, respectively, may be any layers which may react with each other like described above and may have a thickness in the range of ≥ 1 nm to ≤ 100 nm leading to a thickness of the whole structure in the range of ≥ 40µm to ≤ 80µm, for example. The layers 38, 40 may have the same thickness with respect to each other, or they may have different thicknesses. In detail, it is preferable to adapt the respective layer thickness to the reaction which will occur in order to let the complete material react with each other.

For example, the layers 38 may be aluminium layers, whereas the layers 40 may be nickel layers. Consequently in case the high energy material 34 is locally exposed to an energy impact, such as a heat impact, an exothermic reaction between nickel and aluminium will occur to form an intermetallic structure. The reaction front will move through the high energy material 34, thereby reaching a velocity of 5-8 m/s, for example, and creating temperatures of up to 1200°C.

This is visualized in figure 2. At the downstream part of the high energy material 34, the latter comprises the layer structure in unreacted state, i.e. in the layer structure like described above. However, at the upstream part of the material, i.e. when the reaction front has propagated, the high energy material 34 has reacted to form an intermetallic structure 42.

At the border area, particularly each layer 38, 40 preferably may comprise a mixed material zone 44, 46. This mixed material zone 44, 46 comprises the substance of the respective layer 38, 40 as such, as well as a defined amount of the material of the respective adjacent layer 40, 38. Such a mixed material zone 44, 46 decreases the activation energy and improves the speed of the exothermic reaction and thus improves the velocity of the reaction front.

The high energy material 34 may be formed as a foil, for example. However, other possibilities to form the high energy material 34 comprise stripes, which may as well be formed of the layer structure and/or in form of wires, for example. Additionally, it is possible to use a mixture of solid particles to form the high energy material 34. In detail, a mixture of nickel and aluminium particles may be used to form a high energy material 34 in the form of a powder, which in turn may be formed into arbitrary shapes.

Generally, the high energy material 34 may have any shape, for example two or three dimensional shapes, and may be formed of a material of any state, i.e. solid, preferably powder, liquid or gaseous, for example enclosed in a container. Additionally, it is clear for one skilled in the art that the high energy material 34 may consist of the above identified compounds, or it may comprise such compounds.

With respect to the failure current bypass unit 36 and referring back to figure 1, the failure current bypass unit 36 may be equal or comparable to the unit 12 and may thus comprise the same components, which are thus not described in detail here. It may therefore essentially comprise a power semiconductor device 48, preferably comparable to the power semiconductor device 14. The power semiconductor device 48 may be electrically connected to a lower electrode, which might be the lower electrode 14, as well as to an upper electrode, which might be the upper electrode 16.

In case of a failure of the power semiconductor device 14, the failure activates the high energy material 34 due to the generated heat, sparks or arcing, for example, like described above, and may transfer the energy to the power semiconductor device 48 leading a current path to be formed through the latter preferably by a reaction of the semiconductor, i.e. silicon, together with an alloy forming element.

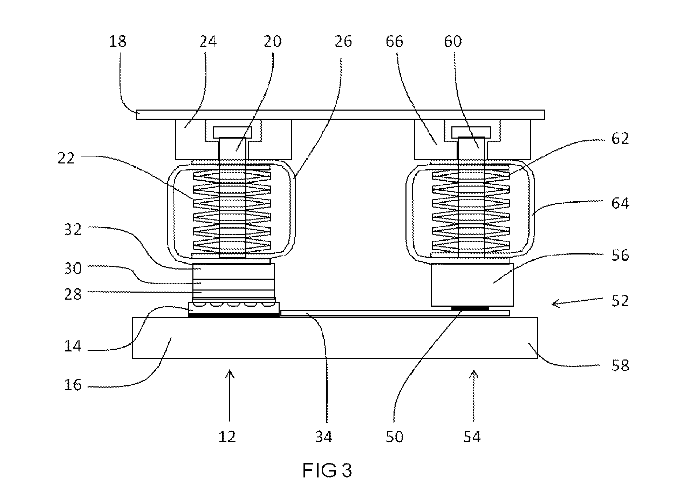

Fig. 3 shows a further embodiment of a power semiconductor arrangement 10 according to the invention. In figure 3, the same or comparable elements are described with the same reference signs with respect to figure 1.

According to figure 3, the arrangement 10 comprises a first unit 12 which is comparable to the unit 12 in figure 1. It thus comprises a power semiconductor device 14 having an emitter electrode and a collector electrode being electrically connected to a lower electrode 16 and an upper electrode 18, respectively. Again, preferably an alloy element being capable of forming an electrically conductive alloy, preferably an eutectic alloy, in case of a failure is provided and the power semiconductor device 14 is contacted and pressed by means of a spring loaded contact piston 20 towards the lower electrode 16. Additionally, a high energy material 34 is provided being connected to the power semiconductor device 14, preferably at its emitter side.

According to figure 3, the high energy material 34 is furthermore connected to an electrical insulator 50. The insulator 50 may thereby disconnect a current conductor 52 being at least partly comprised by the at least one failure current bypass element 54. In detail, according to figure 3, the insulator 50 is arranged between two electrical contact parts 56, 58, wherein at least one contact part 56 is preferably pressed against the insulator 50 by a contact piston 60, preferably being spring loaded by a spring 62. Again, a bypass 64 may be provided together with at least one connector 66 connecting the contact piston 60 with the upper electrode, for example the electrode 18. Additionally, the failure current bypass unit 54 may be connected to a lower electrode, for example the electrode 16, which in this case preferably forms one contact part 58. In the latter case, the high energy material 34 may be used to at least partly damage or destroy the insulator 50, for example a poly-propylene (PP) foil or sheet which may be covered by a metal. By the destruction of this insulator 50, an electrical contact is closed between the contact parts 56, 58 which then serves as electrical bypass parallel to the failed power semiconductor device 14.

It is thereby not necessary that the mechanical spring loaded contact piston 60 above the insulator 50 is similar or identical to the contact piston 20 arranged above the power semiconductor device 14. It is also possible that the failure current bypass unit 54 is located within another, separated, segment of a power electronic arrangement or module, or even outside of it.

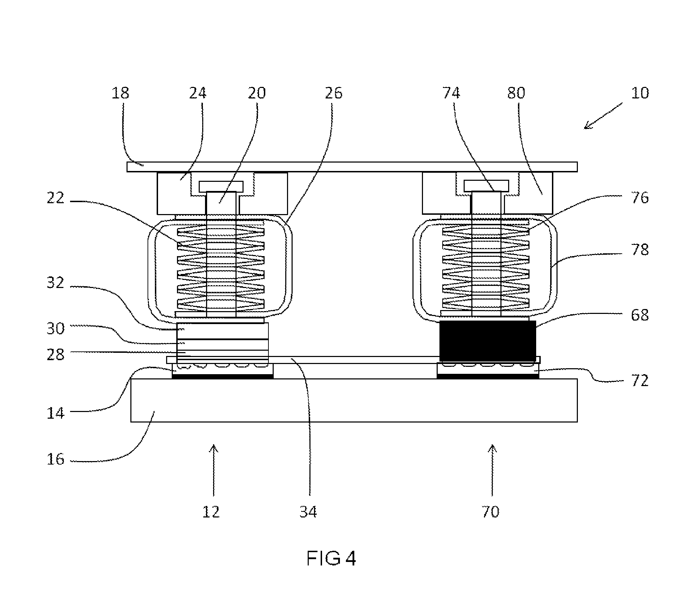

A further embodiment of a power semiconductor arrangement 10 according to the invention is shown in figure 4. Again, the same or comparable elements are described with the same reference signs with respect to figure 1.

The embodiment according to figure 4 addresses the problem that it could be the case that the energy released by the high energy material 34 does not damage another element, such as a power semiconductor device 48 or an insulator 50 strongly enough to activate the failure current bypass unit and thus to generate a current bypass. Consequently, the high energy material 34 is connected to a further high energy material, i.e. the high energy element 68. The high energy material 34 may be used to trigger the further, i.e. more powerful high energy material, or the high energy element 68, respectively, which is capable of generating more energy, preferably in the form of heat, than the high energy material 34. The high energy element 68 may thereby be arranged in a failure current bypass unit 70.

The energy released by this high energy element 68 may damage one or more power semiconductor devices 72 in such a way that an electrically conductive path is formed there, for example by a conductive alloy to be formed like described above. Additionally, or alternatively, it may as a further example influence a further element, such as an electrical insulator, to provide an electrical bypass of the failed power semiconductor device 12.

In detail, the energy released by the high energy material 34 may activate the high energy element 68 in several ways. For example, the high energy material 34 may directly trigger a stronger exothermal reaction in the high energy element 68 compared to the high energy material 34. Additionally, the high energy material 34 may destroy a boundary or separator, respectively, between two containers such, that the contents of both containers are brought into contact and may then exothermally react. For example, a chemical reaction between an oxidant and a reducer may be activated. Furthermore, a substance could be released which reacts with a further element such that an electrical contact is closed. For example, an insulator may be molten, evaporated, etched away or may be dissolved. It may furthermore be provided that a mechanically loaded contact arm is activatable by the high energy material 34 or the high energy element 68 thereby closing a current bypass.

According to figure 4, again, the failure current bypass unit 70 may comprise a contact piston 74 being spring loaded by a spring 76, wherein a bypass 78 may be provided together with one or more connectors 80 connecting the contact piston 74 with an upper electrode, for example the electrode 18. At the bottom side, the failure current bypass unit may be connected to a lower electrode, preferably to the electrode 16, resulting in the unit 12 and the failure current bypass unit 70 to be arranged in parallel.

Of course, each power semiconductor device 14 may be connected to a plurality of further power semiconductor devices, preferably close to the emitter cells on the respective top faces, via a high energy material 34 like described above in order to distribute the short-circuit current to a plurality of current paths.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- 10: power semiconductor arrangement
- 12: unit
- 14: power semiconductor device
- 16: lower electrode
- 18: upper electrode
- 20: contact piston
- 22: spring
- 24: connector
- 26: bypass
- 28: layer
- 30: layer
- 32: layer
- 34: high energy material
- 36: failure current bypass unit
- 38: layer
- 40: layer
- 42: intermetallic structure
- 44: mixed material zone
- 46: mixed material zone
- 48: power semiconductor device
- 50: electrical insulator
- 52: current conductor

- 54: failure current bypass unit
- 56: contact part
- 58: contact part
- 60: contact piston
- 62: spring
- 64: bypass
- 66: connector
- 68: high energy element
- 70: failure current bypass unit
- 72: power semiconductor device
- 74: contact piston
- 76: spring
- 78: bypass
- 80: connector

## Claims

1. Power semiconductor arrangement comprising a power semiconductor device (14), having an emitter electrode and a collector electrode, wherein the collector electrode is electrically connected to a lower electrode (16) and the emitter electrode is electrically connected to an upper electrode (18), wherein the power semiconductor device (14) is arranged to at least one further power semiconductor device in parallel, wherein the arrangement (10) further comprises a high energy material (34) being connected to the power semiconductor device (14) and being connected to at least one failure current bypass unit (36, 54, 70), the failure current bypass unit (36, 54, 70) being arranged in parallel to the power semiconductor device (14) and being activatable by the high energy material (34) to form a current bypass.

2. Power semiconductor arrangement according to claim 1, wherein the at least one failure current bypass unit (36, 54, 70) comprises a power semiconductor device (48).

3. Power semiconductor arrangement according to claim 1, wherein the at least one failure current bypass unit (54, 70) comprises a current conductor (52) being disconnected by an electrical insulator (50), the electrical insulator (50) being at least partly destructible by the high energy material (34).

4. Power semiconductor arrangement according to claim 3, wherein the electrical insulator (50) is arranged between to electrical contact parts (56, 58), wherein at least one contact part (56) is pressed against the insulator (50) by a spring loaded contact piston (60).

5. Power semiconductor arrangement according to any of the preceding claims, wherein an alloy forming element is provided being connected to the power semiconductor device (14).

6. Power semiconductor arrangement according to any of the preceding claims, wherein the high energy material (34) is connected to a high energy element (68).

7. Power semiconductor arrangement according to claim 6, wherein the high energy element (68) comprises at least two different compounds being capable of reacting with each other thereby releasing energy and being separated from each other by a separator, the separator being at least partly destructible by the high energy material (34).

8. Power semiconductor arrangement according to any of the preceding claims, wherein a mechanically loaded contact arm is provided being activatable by the high energy material (34) thereby closing a current bypass.

9. Power semiconductor arrangement according to any of the preceding claims, wherein the high energy material (34) is formed as a layer structure comprising a plurality of alternating layers (38, 40).

10. Power semiconductor arrangement according to claim 9, wherein the layer structure comprises alternating aluminium layers and nickel layers.

11. Power semiconductor arrangement according to claim 9 or 10, wherein at least one layer (38, 40) comprises a mixed material zone (44, 46).

12. Power semiconductor arrangement according to any of claims 9 to 11, wherein the layers (38, 40) each have a thickness in the range of ≥ 1 nm to ≤ 100nm.

13. Power semiconductor arrangement according to any of claims 9 to 12, wherein the high energy material (34) is arranged in the form of a foil or stripe.

14. Power semiconductor arrangement according to any of the preceding claims, wherein the high energy material (34) is formed as a mixture of solid particles.

15. Power semiconductor module comprising a power semiconductor arrangement (10) according to any of the preceding claims.
